# EUROPEAN PATENT APPLICATION

(11) **EP 4 531 516 A2**
(43) Date of publication of application: **02.04.2025**
(21) Application number: 24199588.5
(22) Date of filing: 10.09.2024
(51) Int. Cl.: H10D 30/47, H10D 62/10, H10D 62/17, H10D 62/85, H10D 30/01

(54) **HIGH-ELECTRON-MOBILITY FIELD EFFECT TRANSISTOR WITH CRYSTALLOGRAPHICALLY ALIGNED ELECTRODE REGION STRUCTURE**

(30) Priority: 11.09.2023 US 202363537649 P
(71) Applicant: Infineon Technologies Austria AG, 9500 Villach (AT)
(72) Inventor: BONART, Dietrich, 93077 Bad Abbach (DE); GIETLER, Herbert, 9500 Villach (AT); SAYADI, Luca, 9500 Villach (AT); PRECHTL, Gerhard, 9232 Rosegg (AT)
(74) Representative: JENSEN & SON

(57) **Abstract**

A high-electron mobility transistor includes a semiconductor body including a barrier region, a channel region, and a two-dimensional charge carrier gas channel; first and second electrodes that are each in electrical contact with the two-dimensional charge carrier gas channel; and a gate structure laterally in between the first and second electrodes and configured to control a conduction state of the two-dimensional charge carrier gas channel, wherein the gate structure comprises a gate electrode and a first region of doped type III-V semiconductor material in between the gate electrode and the two-dimensional charge carrier gas channel, wherein the first region of doped type III-V semiconductor material comprises a plurality of side faces that define a plan view geometry of the first region, and wherein in the plan view geometry of the first region at least two lateral boundaries of the first region that intersect one another extend along crystallographically equivalent planes of the doped type III-V semiconductor material.

## Description

### BACKGROUND

Semiconductor transistors, in particular field-effect controlled switching devices such as a MISFET (Metal Insulator Semiconductor Field Effect Transistor), in the following also referred to as MOSFET (Metal Oxide Semiconductor Field Effect Transistor) and an HEMT (high-electron-mobility Field Effect Transistor) also known as heterostructure FET (HFET) and modulation-doped FET (MODFET) are used in a variety of applications. An HEMT is formed from type III-V semiconductor material, e.g., gallium nitride (GaN), gallium arsenide (GaAs), etc. An HEMT includes a two-dimensional charge carrier gas that is created by a heterojunction between two layers of type III-V semiconductor material having different band gaps. This two-dimensional charge carrier gas provides the active device channel that accommodates the load current of the device. Due to the high mobility of carriers within the two-dimensional charge carrier gas, these devices offer very low on-resistance in comparison to other device technologies. For this reason, HEMTs are well suited for power switching applications and/or high frequency applications. HEMTs may be used to control voltages on the order of 5V, 10V, 50V, 100V, 250V, 500V, 1000V, etc. or greater, and/or the control of current in excess of 1A, 5A, 10A, or greater. HEMTs may be operated at switching frequencies on the order of 10 kHz to 50 GHz.

It is desirable to improve the steady state conduction characteristics of an HEMT without detrimentally impacting other parameters including threshold voltage, gate current and linear region characteristics.

### SUMMARY

A high-electron mobility transistor comprises a semiconductor body comprising a barrier region of type III-V semiconductor material and a channel region of type III-V semiconductor material that forms a heterojunction with the barrier region, thereby forming a two-dimensional charge carrier gas channel within the channel region; first and second electrodes that are each in low-ohmic contact with the two-dimensional charge carrier gas channel; and a gate structure disposed on an upper surface of the semiconductor body laterally in between the first and second electrodes and configured to control a conduction state of the two-dimensional charge carrier gas channel, wherein the gate structure comprises a gate electrode and a first region of doped type III-V semiconductor material in between the gate electrode and the two-dimensional charge carrier gas channel, wherein the first region of doped type III-V semiconductor material comprises a plurality of side faces that define a plan view geometry of the first region, and wherein in the plan view geometry of the first region at least two lateral boundaries of the first region that intersect one another extend along crystallographically equivalent planes of the doped type III-V semiconductor material.

A high-electron mobility transistor comprises a semiconductor body comprising a barrier region of type III-V semiconductor material and a channel region of type III-V semiconductor material that forms a heterojunction with the barrier region, thereby forming a two-dimensional charge carrier gas channel within the channel region; a plurality of transistor cells formed in the semiconductor body, each of the transistor cells comprising first and second electrodes that are each in electrical contact with the two-dimensional charge carrier gas channel, and a gate structure comprising a gate electrode and a first region of doped type III-V semiconductor material in between the gate electrode and the two-dimensional charge carrier gas channel; and one or more regions of the doped type III-V semiconductor material that enclose one of the first or second electrodes and provide the first region of doped type III-V semiconductor material for each of the transistor cells, wherein the one or more regions of the doped type III-V semiconductor material comprises a plurality of side faces that define a plan view geometry of the one or more regions, and wherein at least two intersecting lateral boundaries in the plan view geometry of the one or more regions extend along crystallographically equivalent planes of the doped type III-V semiconductor material.

A high-electron mobility transistor comprises a semiconductor body comprising a barrier region of type III-V semiconductor material and a channel region of type III-V semiconductor material that forms a heterojunction with the barrier region, thereby forming a two-dimensional charge carrier gas channel within the channel region; first and second electrodes that are each in electrical contact with the two-dimensional charge carrier gas channel; and a gate structure disposed on an upper surface of the semiconductor body laterally in between the first and second electrodes and configured to control a conduction state of the two-dimensional charge carrier gas channel, wherein the gate structure comprises a gate electrode and a first region of doped type III-V semiconductor material in between the gate electrode and the two-dimensional charge carrier gas channel, wherein the first region of doped type III-V semiconductor material has a wurtzite crystal structure, and wherein from a plan view perspective of the first region side faces of the first region intersect one another at integer multiples of 60°.

### BRIEF DESCRIPTION OF THE DRAWINGS

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
Figure 1, which includes Figs. 1A and 1B, illustrates a high-electron-mobility field effect transistor, according to an embodiment. Fig. 1A illustrates the high-electron-mobility field effect transistor from a cross-sectional perspective; and Fig. 1B illustrates the high-electron-mobility field effect transistor from a plan view perspective.
Figure 2, which includes Figs. 2A and 2B, illustrates a high-electron-mobility field effect transistor, according to an embodiment. Fig. 2A illustrates the high-electron-mobility field effect transistor from a cross-sectional perspective; and Fig. 2B illustrates the high-electron-mobility field effect transistor from a plan view perspective.
Figure 3 illustrates a high-electron-mobility field effect transistor from a plan view perspective, according to an embodiment.
Figure 4 illustrates a high-electron-mobility field effect transistor from a plan view perspective, according to an embodiment.
Figure 5, which includes Figs. 5A, 5B, 5C, 5D, and 5E, illustrates transistor cell layouts of a high-electron-mobility field effect transistor, according to different embodiments.
Figure 6 illustrates a high-electron-mobility field effect transistor from a plan view perspective, according to an embodiment.
Figure 7 illustrates a high-electron-mobility field effect transistor from a plan view perspective, according to an embodiment.
Figure 8 illustrates a high-electron-mobility field effect transistor from a plan view perspective, according to an embodiment.
Figure 9 illustrates a high-electron-mobility field effect transistor from a plan view perspective, according to an embodiment.

### DETAILED DESCRIPTION

Embodiments of a high-electron mobility transistor with electrode structures comprising regions of doped type III-V semiconductor material with an advantageous geometry are described herein. These electrode structures may include a gate structure with a doped region of type III-V semiconductor material that is used to adjust the threshold voltage of the device. These electrode structures may also include a drain structure with a doped region of type III-V semiconductor material that is used to reduce dynamic RDS_{ON} (drain-source on-resistance). In either case, the doped type III-V semiconductor material is structured such that intersecting side faces of the region extend along crystallographically equivalent planes of the semiconductor material. This alignment of the side faces is realized by setting the intersection angle between intersecting pairs of the doped type III-V semiconductor material to correspond with the natural orientation of the same axis crystallographic planes from the material. This technique and corresponding structure creates homogenous surfaces in the doped type III-V semiconductor material, which leads to uniform behavior and mitigates leakage.

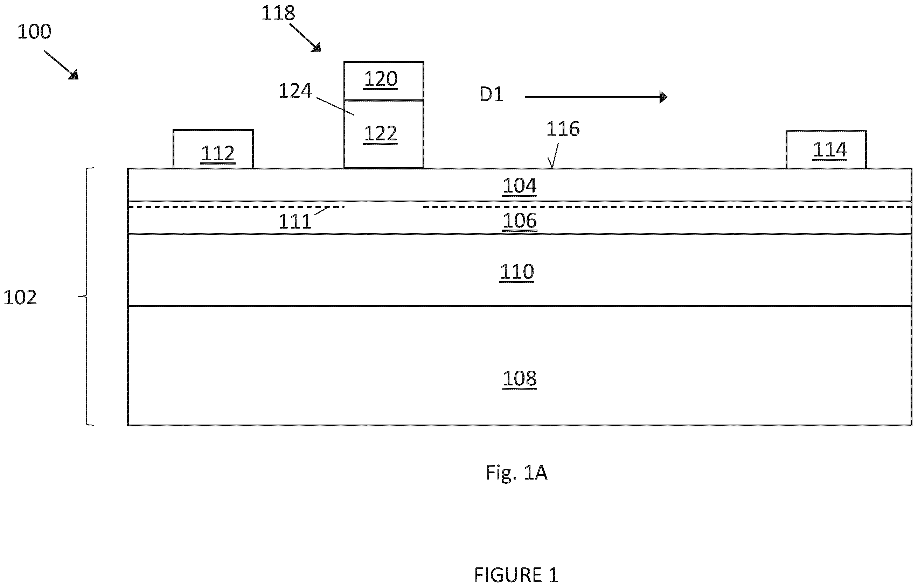

Referring to Fig. 1A, a high-electron mobility transistor 100 is shown, according to an embodiment. The high-electron mobility transistor 100 comprises a semiconductor body 102. The semiconductor body 102 comprises a barrier region 104 of type III-V semiconductor material disposed on a channel region 106 of type III-V semiconductor material. Due to a bandgap difference in the material which form the barrier region 104 and the channel region 106, a two-dimensional charge carrier gas channel 111 forms near a heterojunction interface between the barrier region 104 and the channel region 106. The bandgap difference may result from a difference in metal alloy concentration as between the barrier region 104 and the channel region 106. Exemplary III-V semiconductor materials that may be used for the barrier region 104 and the channel region 106 include gallium nitride (GaN), gallium arsenide (GaAs), aluminium arsenide (AlAs), indium nitride (InN), indium arsenide (InAs), etc., and ternary or quarternary III-V materials such as aluminium gallium nitride (AlGaN), aluminium gallium arsenide (AlGaAs), indium gallium nitride (InGaN), indium aluminium gallium nitride (InAIGaN), etc. In general, the two-dimensional charge carrier gas channel 111 may be a 2DEG (two-dimensional electron gas) or a 2DHG (two-dimensional hole gas). According to an embodiment, the barrier region 104 is a region of AlGaN, the channel region 106 is a region of GaN or AlGaN with a lower aluminum content than the barrier region 104, and the two-dimensional charge carrier gas channel 111 is a 2DEG.

The semiconductor body 102 further comprises a base substrate 108. The base substrate 108 is a lower part of semiconductor body 102 that is below the active region formed by the barrier region 104 and the channel region 106. The base substrate 108 may correspond to a semiconductor region that is used to epitaxially grow type III-nitride semiconductor material thereon. This base substrate 108 may comprise a variety of semiconductor materials such as silicon (Si), sapphire, silicon carbide (SiC) or silicon germanium (SiGe), etc. The base substrate 108 may be provided from a commercially available semiconductor wafer, such as a bulk silicon wafer or a SOI (silicon on insulator) wafer.

The semiconductor body 102 may additionally comprise an intermediate region 110 disposed in between the base substrate 108 and the active region. The intermediate region 110 may comprise multiple different regions or layers that are not specifically identified in the figure. For example, the intermediate region 110 may comprise a lattice transition region that is configured to alleviate mechanical stress attributable to crystalline lattice mismatch between the base substrate 108 and the active region formed by the barrier region 104 and the channel region 106. This lattice transition region may comprise different layers of type III-V semiconductor material, e.g., GaN/AIGaN/AIN layers with varying alloy content, for example. Separately or in combination, the intermediate region 110 may comprise a back-barrier region that interfaces with a lower side of the channel region 106 and is configured to increase carrier confinement in the channel region 106 and prevent leakage through lower part of the semiconductor body 102. This back-barrier region 104 may comprise AlGaN with a higher aluminum content than the channel region 106, and may optionally be doped with C and or Fe, for example.

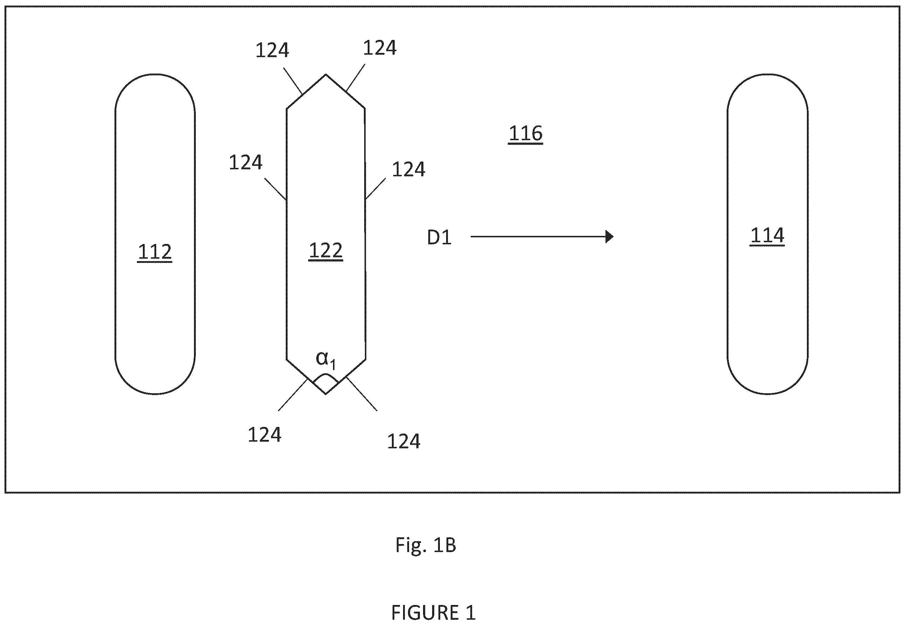

The high-electron mobility transistor 100 comprises source and drain electrodes 112, 114 that are disposed on the upper surface 116 of the semiconductor body 102. The source and drain electrodes 112, 114 are laterally spaced apart from one another in a current flow direction D1 of the device. The source and drain electrodes 112, 114 are each in electrical contact with the two-dimensional charge carrier gas channel 111. This electrical contact may be effectuated by trenches that extend into the upper surface 116 of the semiconductor body 102 (not shown in Figure 1) and are filled with a conductive metal or doped semiconductor. The connection between the source and drain electrodes 112, 114 may be a low-ohmic (i.e., non-rectifying) connection, or may have rectifying (i.e., Schottky) behavior).

The high-electron mobility transistor 100 comprises a gate structure 118 that is disposed on upper surface 116 of the semiconductor body 102 laterally in between the source and drain electrodes 112, 114. The gate structure 118 comprises a gate electrode 120 and a first region 122 of doped type III-V semiconductor material in between the gate electrode 120 and the two-dimensional charge carrier gas channel 111. The gate electrode 120 may be formed from an electrically conductive material, e.g., tungsten, aluminum, titanium, titanium nitride, highly doped monocrystalline or polycrystalline semiconductors, etc. The first region 122 of doped type III-V semiconductor material is configured to locally deplete the two-dimensional charge carrier gas channel 111 in the absence of gate bias, thereby configuring the high-electron mobility transistor 100 as a normally-off device. According to an embodiment, the first region 122 of doped type III-V semiconductor material comprises p-type GaN or alloys thereof (e.g., p-type AlGaN). This structure may be used to generate an electric field that depletes two-dimensional charge carrier gas channel 111 this is a 2DEG. Device parameters including thickness of the first region 122 of doped type III-V semiconductor material, dopant concentration of the first region 122 of doped type III-V semiconductor material, and distance between the first region 122 of doped type III-V semiconductor material and the two-dimensional charge carrier gas channel 111 may be tailored such that the two-dimensional charge carrier gas channel 111 underneath the gate structure 118 is depleted at zero-gate-source bias, thereby configuring the high-electron mobility transistor 100 as a normally-off device. In the depicted embodiment, the barrier region 104 has a uniform thickness underneath and outside of gate structure 118. In other embodiments, a thickness of the barrier region 104 may be modulated to locally increase or decrease the separation distance between the gate structure 118 and the two-dimensional charge carrier gas channel 111.

The high-electron mobility transistor 100 may comprise additional layers and/or structures on the upper surface 116 of the semiconductor body 102 that are not shown for the sake of simplicity. These additional layers and/or structures may comprise further semiconductor layers, e.g., capping layers, electrically insulating layers and/or protective layers, e.g., passivation layers, interlayer dielectrics, etc., metallization layers, e.g., metal contact pads, bond pads, etc.

The working principle of the high-electron mobility transistor 100 is as follows. The gate structure 118 is configured to control a conductive connection between the source and drain electrodes 112, 114 by controlling a conductive state of the two-dimensional charge carrier gas channel 111. The gate structure 118 provides on/off control through the modulation of an electric that depletes or repopulates two-dimensional charge carrier gas channel 111 of carriers underneath the gate structure 118. In the case of a normally-off device, the two-dimensional charge carrier gas channel 111 is depleted underneath the two-dimensional charge carrier gas channel 111 at zero gate-source bias. The device is turned on by applying a gate-source bias that alters the electric field underneath the gate structure 118, thereby populating the two-dimensional charge carrier gas channel 111 underneath the gate structure 118 and completing the electrical connection between the source and drain electrodes 112, 114. A normally-on device works similarly, except that a negative gate bias is applied to the gate structure 118 to deplete the two-dimensional charge carrier gas channel 111 underneath the gate structure 118 and turn the device off.

The first region 122 of doped type III-V semiconductor material is a structured region of material that is formed on the upper surface 116 of the semiconductor body 102. According to one technique, a blanket layer of doped type III-V semiconductor material with the requisite thickness and doping concentration for the first region 122 is epitaxially grown on the upper surface 116 of the semiconductor body 100 and this blanket layer is subsequently structured, e.g., using a masked etching process. The first region 122 of doped type III-V semiconductor material comprises side faces 124 that are created by the structuring process. These side faces 124 are oriented transversely to the upper surface 116 of the semiconductor body 102. For example, the side faces 124 may be perpendicular to the upper surface 116 of the semiconductor body 102.

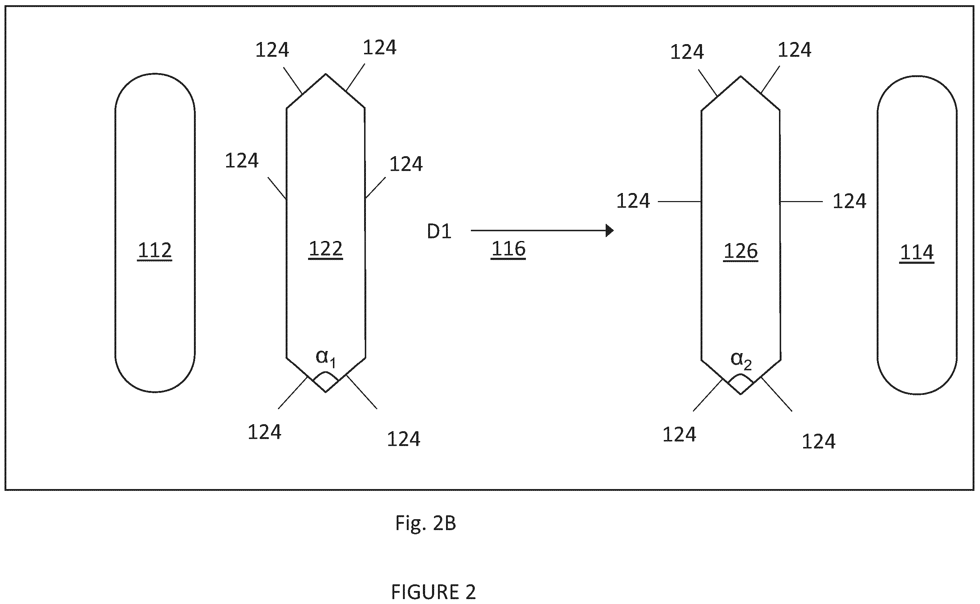

Referring to Fig. 1B, the side faces 124 define a geometry of the first region 122 from a plan view perspective. That is, the side faces 124 form the lateral boundaries of the first region 122 when seen from above. In Fig. 2B, the gate electrode 120 is omitted for the ease of illustration. The plan view geometry of the gate electrode 120 may mimic that of the first region 122. For example, the gate electrode 120 portion of the gate structure 118 may be created from a blanket layer of conductive material that formed on top of the blanket layer of type III-V semiconductor material which forms the first region 122, with both blanked layers being structured simultaneously by a common mask or lithographically aligned masks.

The high-electron mobility transistor 100 is configured such that at least two of the side faces 124 from the first region 122 of doped type III-V semiconductor material that intersect one another extend along crystallographically equivalent planes of the type III-V semiconductor material. That is, at least one pair of the side faces 124 that forms an angled intersection with one another is arranged such that both of the side faces 124 from the pair extend along a crystallographically equivalent plane of the type III-V semiconductor material. As used herein, the term "crystallographically equivalent plane" refers to two-dimensional lattice planes that pass through common lattice points in the underlying crystal structure.

Configuring the high-electron mobility transistor 100 such that intersecting pairs of the side faces 124 each extend along crystallographically equivalent planes of the type III-V semiconductor material requires appropriate selection of the intersection angle α₁ between the intersecting side faces 124. Figure 1 shows the intersection angle α₁ between one pair of side faces 124, but the discussion below is equally applicable to any pair of the side faces 124 that intersect one another. The intersection angle α₁ must correspond to angle that exists between the crystallographically equivalent planes of the semiconductor material, which is determined by the underlying unit crystal structure of the semiconductor material. One crystal type that is commonly seen in power devices is the wurtzite crystal structure. Examples of semiconductor materials with a wurtzite crystal structure include gallium nitride, aluminum nitride, boron nitride and so-called α-SiC (silicon carbide). Thus, in the case that the first region 122 of doped type III-V semiconductor material is a region of p-type GaN or alloys thereof, it has a wurtzite crystal structure. A wurtzite crystal structure comprises 6 crystallographically equivalent planes that form a hexagon in a plane running perpendicular to the c-axis. Thus, each intersecting pair of these crystallographically equivalent planes is oriented at 60° relative to another, and every crystallographically equivalent planes running parallel to the c-axis is oriented at integer multiples of 60° relative to another. Accordingly, forming the side faces 124 to intersect one another and extend along a crystallographically equivalent planes of the first region 122 of doped type III-V semiconductor material may be achieved by orienting the side faces 124 to extend along a common axis of the material and have an intersection angle α₁ with one another that is either 60° or a multiple thereof, e.g., 120°, 240° or 300°. A mask used to structure the first region 122 of doped type III-V semiconductor material may be created according to a design rule that requires each sidewall of the mask to be oriented at integer multiples of 60°. Further, the mask may be formed such that the sidewalls of the mask align with the underlying lattice planes of the semiconductor material, e.g., using optically detectable features. In this way, every sidewall in the doped type III-V semiconductor material formed by the masked etching will align with crystallographically equivalent plane. Similar considerations may be used to structure semiconductor materials with other crystal types, e.g., cubic, orthorhombic, etc.

By configuring the high-electron mobility transistor 100 such that intersecting pairs of the side faces 124 from the first region 122 of doped type III-V semiconductor material extend along a crystallographically equivalent planes of the type III-V semiconductor material, roughened surfaces of the doped type III-V semiconductor material are eliminated from the gate structure 118. A roughened surface refers to a surface of semiconductor material that comprises step-shaped transitions between multiple lattice planes. A roughened surface may result from cutting or otherwise forming semiconductor surfaces at angles that deviate from the crystallographically equivalent planes of the semiconductor material, e.g., forming angles other than integer multiples of 60° in the above wurtzite crystal structure example. A roughened surface may also result from forming non-acute transitions, e.g., rounded corners, in the semiconductor material. In either case, the structuring of the material creates discrete steps and transitions at a microscopic level which correspond to transitions between the underlying lattice planes. These roughened surfaces may increase the gate-source or gate-drain leakage currents by providing paths for carriers to flow along. The technique described herein can be used to at least reduce the presence of roughened surfaces and thereby improve the leakage characteristic of the device.

According to an embodiment, every one of the side faces 124 from the first region 122 extends along one of the crystallographically equivalent planes of the doped type III-V semiconductor material. Fig. 1 may represent one example of this embodiment, wherein the first region 122 of doped type III-V semiconductor material forms a simple enclosed shape with a plurality of the side faces 124 defining the geometry of this enclosed shape. Each of these side faces 124 may be arranged to extend along one of the crystallographically equivalent planes of the doped type III-V semiconductor material. In particular, the first region 122 may be structured such that each intersection angle α₁ between two side faces 124 is a 60° angle. In other embodiments, one or more of the intersection angles α₁ may be a multiple of 60°, e.g., 120°, 240° or 300°.

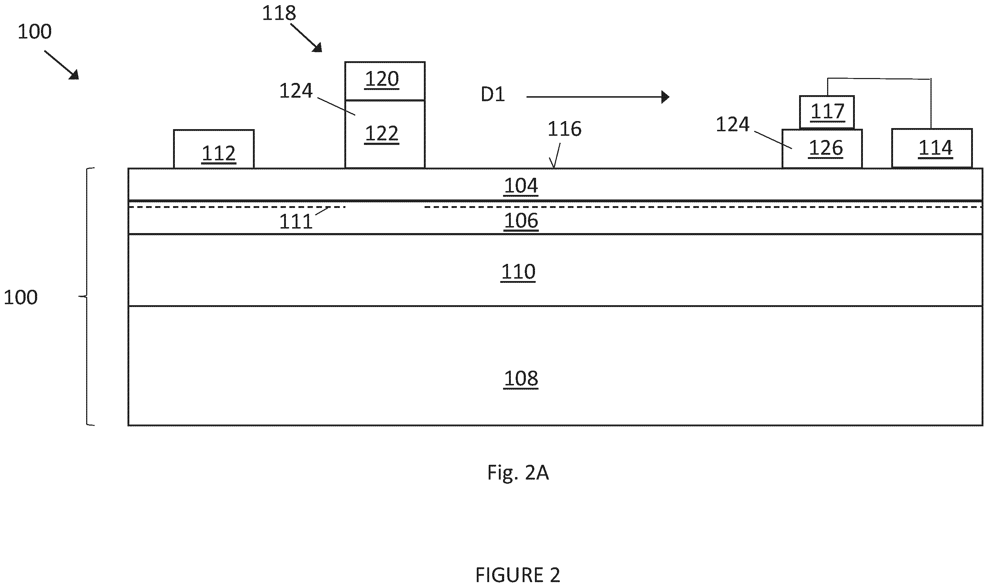

Referring to Fig. 2A, a high-electron mobility transistor 100 is shown, according to another embodiment. This high-electron mobility transistor 100 is identical to that of Figure 1, except that the device has a modified drain structure. The drain structure comprises a second region 126 of doped type III-V semiconductor material disposed on the upper surface 116 of the semiconductor body 102, The upper surface 116 of the semiconductor body 102 is tied to a drain potential by a secondary electrode 117. The drain structure additionally comprises the drain electrode 114 being laterally spaced apart from the second region 126 of doped type III-V semiconductor material and disposed on the upper surface 116 of the semiconductor body 102. The drain structure comprising the second region 126 of doped type III-V semiconductor material is configured to reduce the dynamic RDS_{ON} of the device. The second region 126 of doped type III-V semiconductor material may be formed according to a similar or identical technique as the first region 122 of doped type III-V semiconductor material described above. In an embodiment, the second region 126 of doped type III-V semiconductor material is a region of p-type GaN with the two-dimensional charge carrier gas channel 111 being a 2DEG channel. The second region 126 of doped type III-V semiconductor material comprises side faces 124 that define the geometry of the second region 126 from a plan view perspective in a similar manner as described above.

Referring to Fig. 2B, according to an embodiment, the high-electron mobility transistor 100 is configured such that at least two of the side faces 124 from the second region 126 of doped type III-V semiconductor material that intersect one another extend along a crystallographically equivalent plane of the type III-V semiconductor material. In a similar manner as described above, this avoids forming roughened surfaces in the second region 126 of doped type III-V semiconductor material, thereby improving the leakage characteristics of the device. As shown, the second region 126 of doped type III-V semiconductor material may be formed to have an identical geometry as the first region 122 of doped type III-V semiconductor material. Separately or in combination, the second region 126 of doped type III-V semiconductor material may be configured such that each of its side faces 124 extend along one of the crystallographically equivalent planes of the doped type III-V semiconductor material.

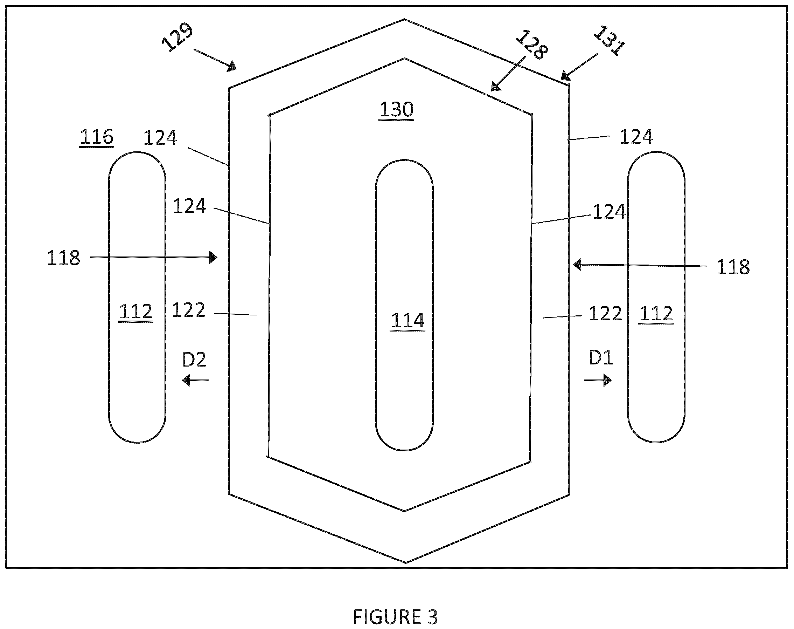

Referring to Figure 3, a layout of the high-electron mobility transistor 100 is shown, according to another embodiment. In this embodiment, the high-electron mobility transistor 100 comprises two drain electrodes 114 arranged on opposite sides of one source electrode 122. The high-electron mobility transistor 100 is configured conduct in a first current flow direction D1 between the source electrode 112 and one of the drain electrodes 114 and to conduct in a second current flow direction D2 between the source electrode 112 and the other one of the drain electrodes 114, wherein the second current flow direction D2 is antiparallel to the first current flow direction D1.

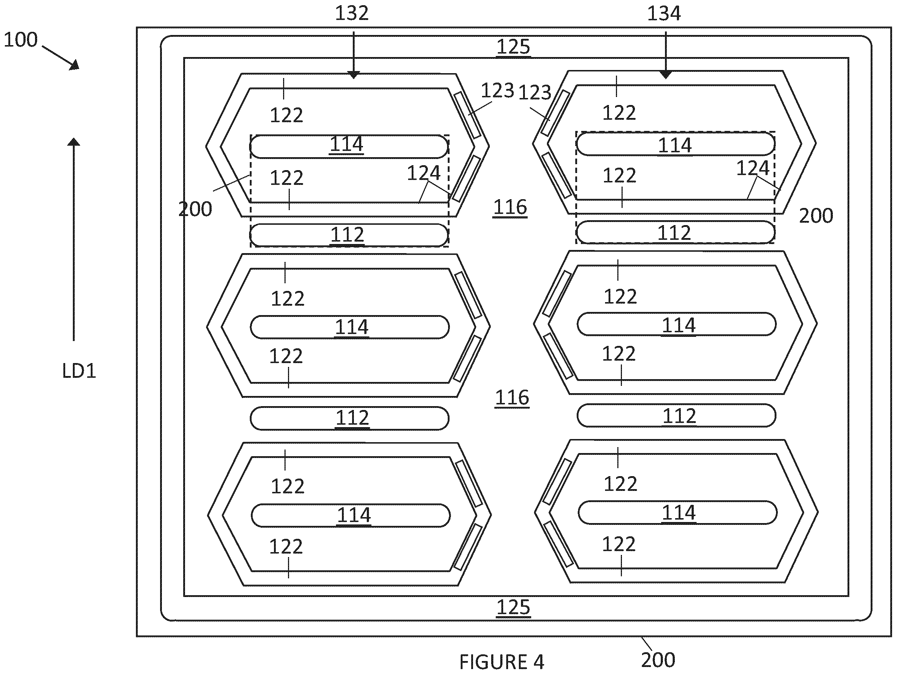

In the device of Figure 3, the gate structure 118 including the first region 122 is provided from an enclosed ring 129 of the doped type III-V semiconductor material. The enclosed ring 129 of the doped type III-V semiconductor material surrounds the source electrode 112. This provides a gate structure 118 controlling current flowing in both the first current flow direction D1 and the second current flow direction D1. A similar concept may be used to create a device with an enclosed ring 129 surrounding one of the drain electrodes 114 in between two of the source electrodes 114, e.g., as illustrated below with reference to Figure 4.

The enclosed ring 129 of the doped type III-V semiconductor material may be structured such that at least two of the side faces 124 from the enclosed ring 129 that intersect one another extend along a crystallographically equivalent plane of the type III-V semiconductor material in a similar manner as described above. In particular, the enclosed ring 129 forms a first closed shape 128 that faces and surrounds an interior region 130, wherein the source electrode 112 is arranged within the interior region 130. According to an embodiment, at least two of the side faces 124 which form the first closed shape 128 and intersect one another extend along crystallographically equivalent planes of the doped type III-V semiconductor material. In a particular embodiment of this, each one of the side faces 124 which form the first closed shape 128 extend along crystallographically equivalent planes of the doped type III-V semiconductor material. The enclosed ring 129 additionally forms a second closed shape 128 form a second closed shape 132 that defines an outer periphery of the enclosed ring 129. According to an embodiment, at least two of the side faces 124 which form the second closed shape 132 and intersect one another extend along crystallographically equivalent planes of the doped type III-V semiconductor material. In a particular embodiment of this, each one of the side faces 124 which form the second closed shape 132 extend along crystallographically equivalent planes of the doped type III-V semiconductor material..

Referring to Figure 4, a high-electron mobility transistor 100 is shown, according to another embodiment. The high-electron mobility transistor 100 comprises a plurality of transistor cells 200 formed in the semiconductor body 100. Each transistor cell 200 comprises source and drain electrodes 112, 114 that are each in electrical contact with the two-dimensional charge carrier gas channel 111 (e.g., as seen in Figure 1), a gate electrode 120 (e.g., as seen in Figure 1), a first region of doped type III-V semiconductor material 122 in between the gate electrode 120 and the two-dimensional charge carrier gas channel two-dimensional charge carrier gas channel 111 and gate vias 123 for electrically connecting the first region of doped type III-V semiconductor material 122 with an upper level gate metallization. This multi-cell configuration may be used to increase the current carrying capacity through parallelization.

The first region of doped type III-V semiconductor material 122 for each of the transistor cells 200 is provided by a plurality of enclosed rings of the doped type III-V semiconductor material. These enclosed rings may have a similar geometry as the enclosed ring 129 from the device described with reference to Figure 4. Thus, the regions of doped type III-V semiconductor material 122 which form the first region of doped type III-V semiconductor material 122 for each of the transistor cells 200 may conform to the requirements that the side faces 124 extend along the crystallographically equivalent planes of the doped type III-V semiconductor material as described above. In the depicted embodiment, the enclosed rings are configured to surround one the drain electrodes 114 for each of the transistor cells 200, with the source electrode 112 for each of the transistor cells 200 being disposed outside of the enclosed ring. In principle, either arrangement is possible, i.e., the enclosed rings may surround the drain electrode 114 or the source electrode 112 for each of the transistor cells 200.

The high-electron mobility transistor 100 comprises a first row 132 of the transistor cells 200 and a second row 134 of the transistor cells 200 adjacent to the first row 134. In the depicted embodiment, each of the transistor cells 200 from the first row 132 is aligned with each of the transistor cells 200 from the second row 134 in a lateral direction LD1 that is parallel to the current flow directions of the transistor cells 200. That is, the source and drain electrodes 112, 114 of the transistor cells 200 from the first row 132 align with the source and drain electrodes 112, 114 of the transistor cells 200 from the first row 132 in the in the lateral direction LD1. In practice, the number of transistor cells 200 per row and/or number of rows per device may vary from what is shown.

The high-electron mobility transistor 100 may comprise an edge termination electrode 125 that is disposed between the transistor cells 200 from the first and second rows 132, 134 and an outer edge side 134 of the semiconductor body. The edge termination electrode 125 may be configured to reduce an electric field strength at the edges of the device. The edge termination electrode 125 may be connected to a fixed potential such as a source potential. In this case, the edge termination electrode 125 is a continuous electrode structure that extends adjacent to the transistor cells 200 from each of the first and second rows 132, 134.

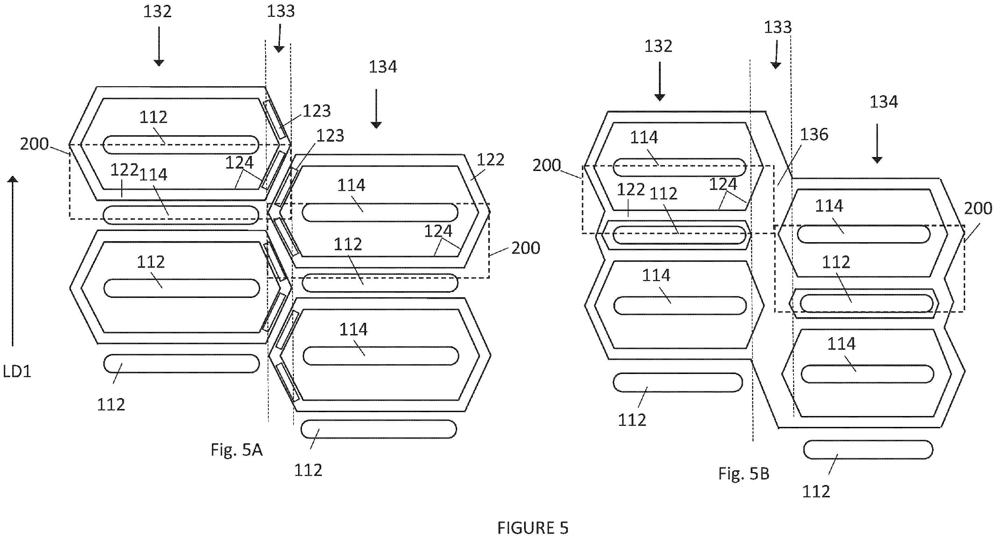

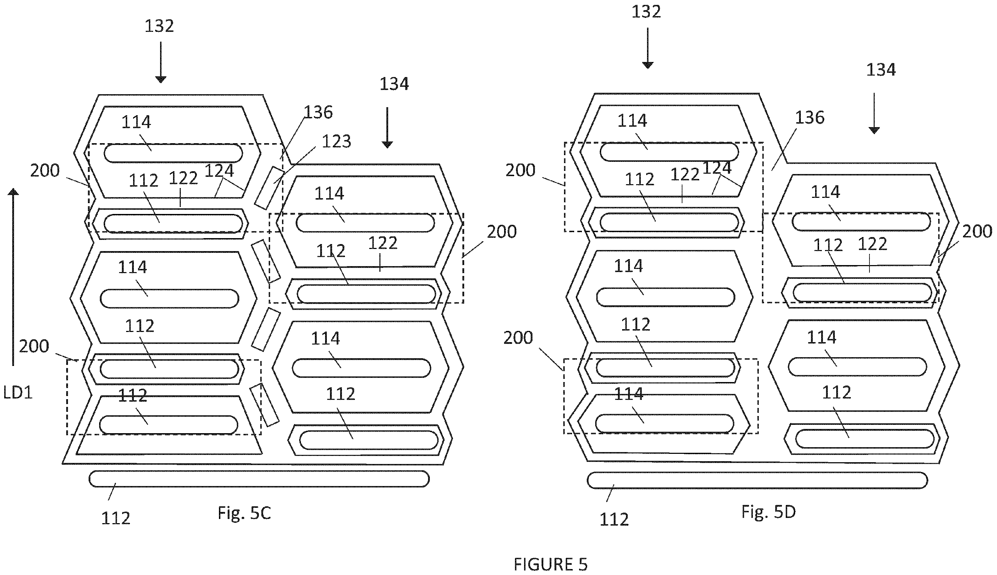

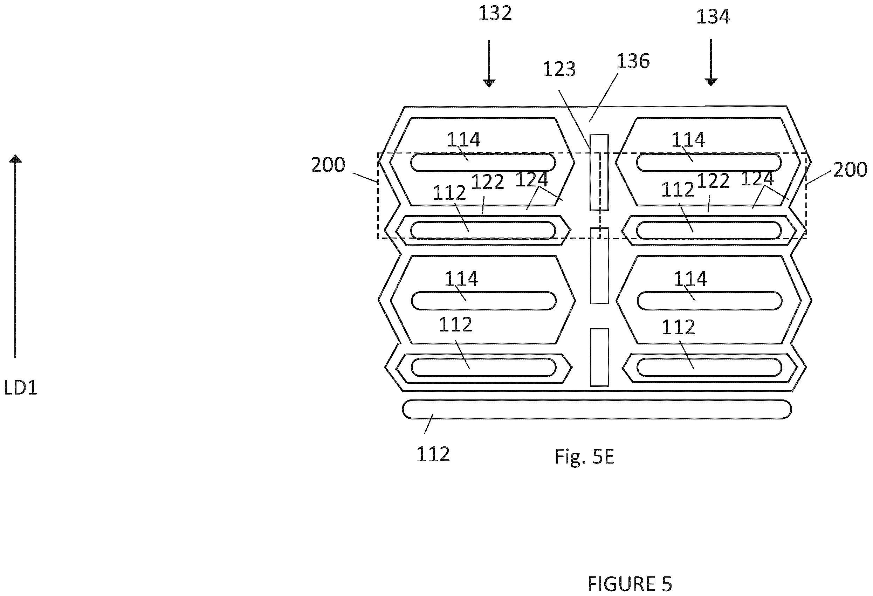

Referring to Figure 5, various layouts for a high-electron mobility transistor 100 comprising a plurality of transistor cells 200 are shown. These figures show only a partial view of the device to illustrate the layout of the transistor cells 200 relative to one another and omit the edge termination electrodes 125.

Referring to Fig. 5A, in this embodiment, the transistor cells 200 from the first row 132 are offset from the transistor cells 200 from the second row 134 in the lateral direction LD1. That is, source and drain electrodes 112, 114 of the transistor cells 200 from the first row 132 do not align with the source and drain electrodes 112, 114 of the transistor cells 200 from the first row 132 in the lateral direction LD1. Furthermore, the enclosed rings of the doped type III-V semiconductor material that provide the first region of doped type III-V semiconductor material 122 for the transistor cells 200 from the first row 132 overlap with the enclosed rings of the doped type III-V semiconductor material that provide the first region of doped type III-V semiconductor material 122 for the transistor cells 200 from the second row 134 in a central region 133 of the high-electron mobility transistor 100. Due to the angled orientation of the side faces 124 of the doped type III-V semiconductor that is dictated by the design rules, it is possible to provide these partially overlapping first and second rows 132, 134 with a dovetailed arrangement of the enclosed rings, thereby increasing space efficiency.

Referring to Fig. 5B, the high-electron mobility transistor 100 comprises a continuous region of the doped type III-V semiconductor material that provides the first region of doped type III-V semiconductor material 122 for each of the transistor cells 200. The continuous region comprises a gate bus 136 that connects with the first region of doped type III-V semiconductor material 122 for each of the transistor cells 200. This layout in essence can correspond to that of Fig. 5A, except that the transistor cells 200 from the first and second rows 132, 134 are merged together. The continuous region of the doped type III-V thus may conform to the design requirements of the doped type III-V semiconductor material 122 in each of the above-described embodiments. In particular, any one or all of the intersecting side faces 124 from the continuous region of the doped type III-V semiconductor material be oriented along the crystallographically equivalent planes of the doped type III-V semiconductor material.

Referring to Figs. 5C, 5D and 5E, further layouts of the high-electron mobility transistor 100 are shown. One drawback of the shifted geometry of the embodiments described with reference to Figs. 5A and 5B is that it creates a region of unused space and may require shifting of the edge termination. The embodiments of Figs. 5C, 5D and 5E avoid this arrangement and provide first and second rows 132, 134 that are equidistant to the edge termination. In the embodiments of Figs. 5C and 5D, the outermost one of the transistor cells 200 from the first row 132 is differently configured from every other one of the transistor cells 200 from the first row 132 and the second row 134. As a result, the first and second rows 132, 134 of the transistor cells 200 are terminated along the same plane. The embodiments of Figs. 5C and 5D only differ from one another with respect to the geometry of the opening in the continuous region. In the embodiments of Fig. 5C and 5D this opening is adapted to eliminate acute angles. By configuring the doped type III-V semiconductor material such that every intersection between the side faces 134 forms an oblique angle, localized occurrences of high electric field may be avoided. In the embodiment of Fig. 5E, each of the transistor cells 200 from the first row 132 is aligned with each of the transistor cells 200 from the second row 134 in in the lateral direction LD1 of the transistor cells 200, e.g., in a similar manner as described above. However, the transistor cells 200 are merged together such that the high-electron mobility transistor 100 comprises a continuous region of the doped type III-V semiconductor material that provides the first doped region of the gate structure for each of the transistor cells 200 and comprises a gate bus 136 that connects with the first doped region of the gate structure for each of the transistor cells 200, e.g., in a similar manner as described above.

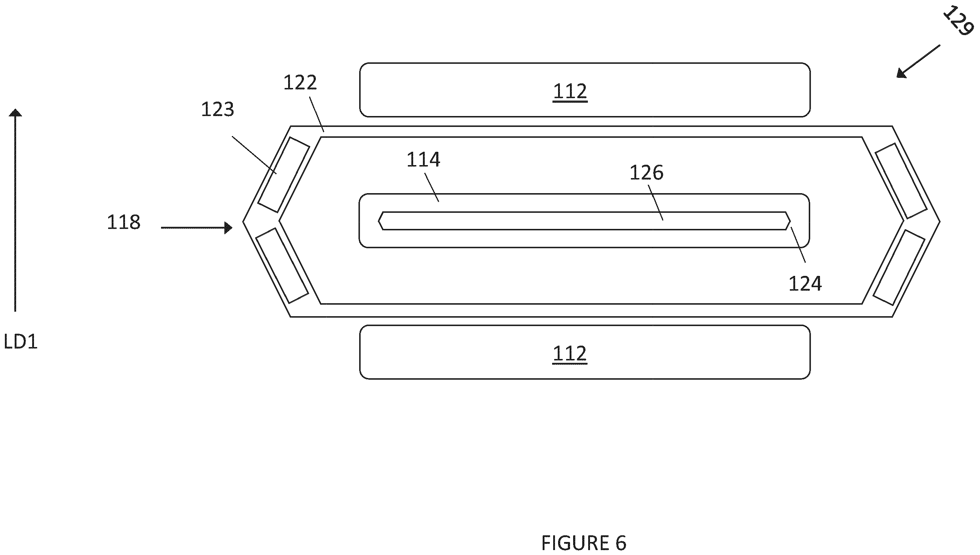

Referring to Figure 6, a layout of a high-electron mobility transistor 100 is shown, according to another embodiment. In this example, the high-electron mobility transistor 100 comprises a gate structure 118 with an enclosed ring 129 of the doped type III-V semiconductor material, wherein the enclosed ring 129 may be structured such that at least two of the side faces 124 from the enclosed ring 129 that intersect one another extend along a crystallographically equivalent plane of the type III-V semiconductor material in a similar manner as described above. Additionally, the high-electron mobility transistor 100 is configured with a drain structure that comprises a second region 126 of doped type III-V semiconductor material. In this case, the second region 126 of doped type III-V semiconductor material is structured such that at least two of the side faces 124 from the second region 126 of doped type III-V semiconductor material intersect one another extend along a crystallographically equivalent plane of the type III-V semiconductor material in a similar manner as described above. In this case, the second region 126 of doped type III-V semiconductor material is configured as an elongated stripe within the confines of the drain electrode 114.

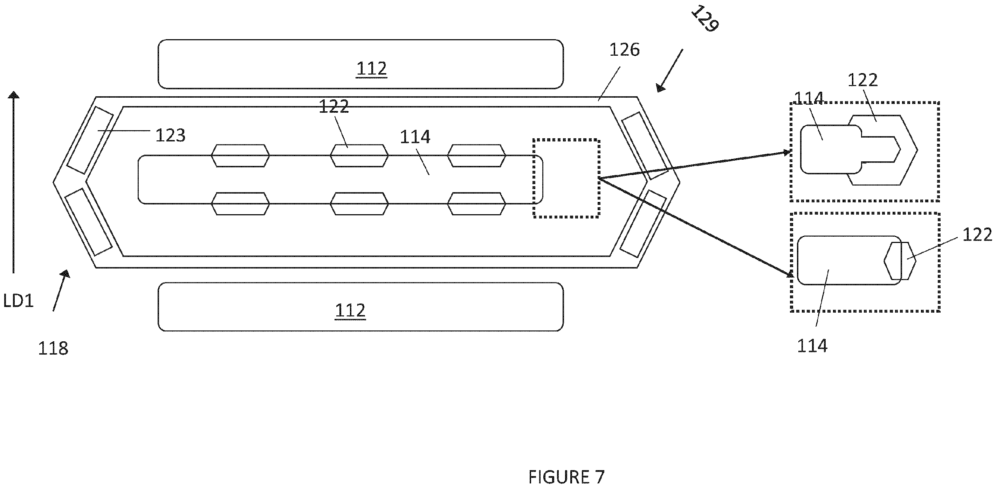

Referring to Figure 7, a layout of a high-electron mobility transistor 100 is shown, according to another embodiment. The high-electron mobility transistor 100 of Figure 7 differs from that of Figure 6 in that the drain structure is configured with a plurality of the second regions 126 of doped type III-V semiconductor material around the periphery of the drain electrode 114. On the right side of the figure, two potential variations are shown. In each case, the second regions 126 are disposed at terminating ends of the elongated drain electrode 114. These second regions 126 may be provided in addition to or instead of the plurality of the second regions 126 of doped type III-V semiconductor material shown on the left side of the figure.

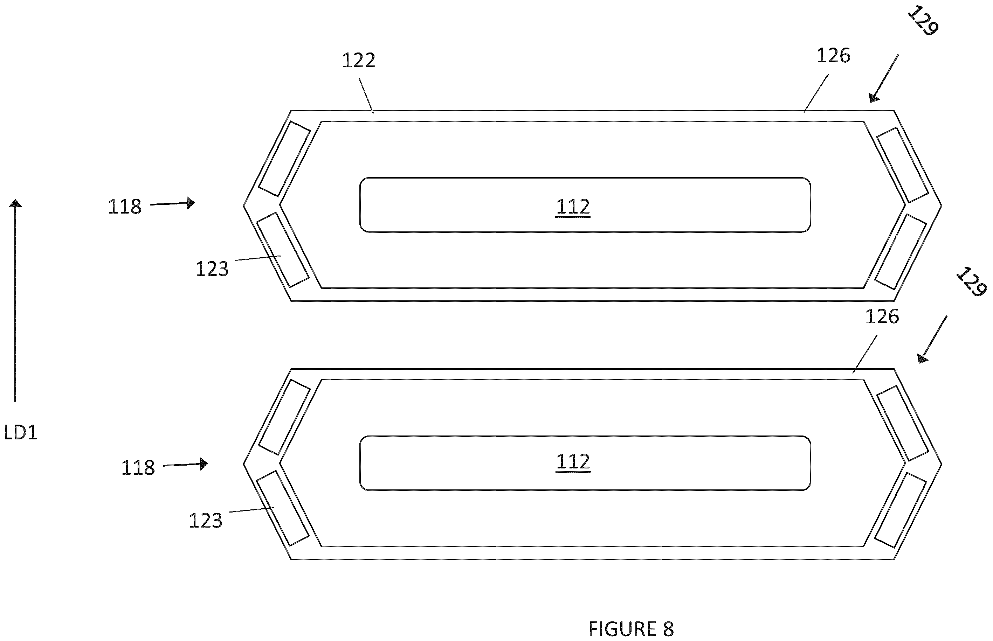

Referring to Figure 8, a layout of a high-electron mobility transistor 100 is shown, according to another embodiment. In this case, the high-electron mobility transistor 100 is configured as a bidirectional switch, wherein the device is configured to conduct in either direction between two source electrodes 112, depending on the bias polarity between these source electrodes 112. In this device, the high-electron mobility transistor 100 comprises a gate structure 118 with an enclosed ring 129 of the doped type III-V semiconductor material may be structured such that at least two of the side faces 124 from the enclosed ring 129 that intersect one another extend along a crystallographically equivalent plane of the type III-V semiconductor material in a similar manner as described above.

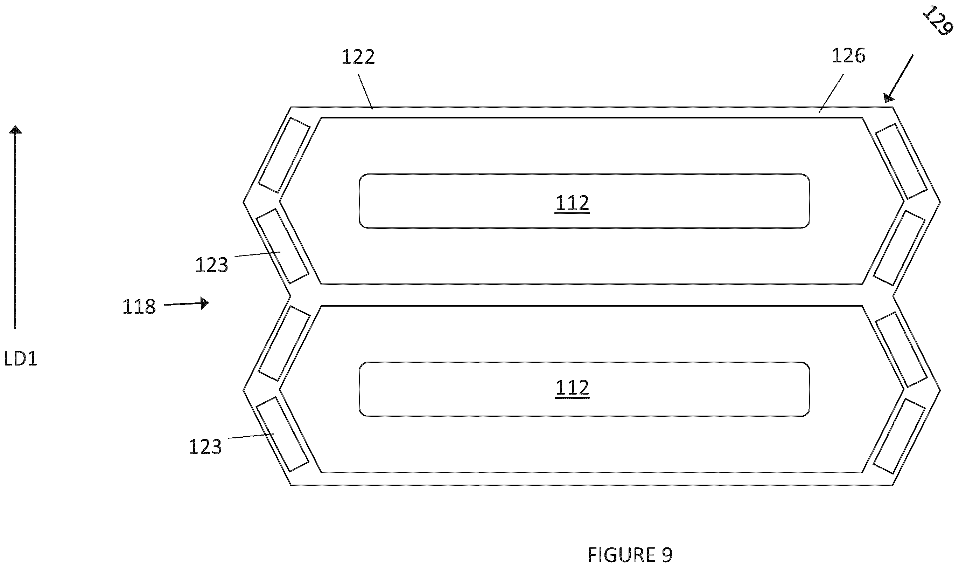

Referring to Figure 9, a layout of a high-electron mobility transistor 100 is shown, according to another embodiment. The high-electron mobility transistor 100 of Figure 9 is configured as a bidirectional switch in a similar manner as the device of Figure 9. The high-electron mobility transistor 100 of Figure 9 differs from that of Figure 8 in that the enclosed rings 129 of the gate structure 118 are merged together to form a single continuous structure.

Although the present disclosure is not so limited, the following numbered examples demonstrate one or more aspects of the disclosure.

Example 1. A high-electron mobility transistor, comprising: a semiconductor body comprising a barrier region of type III-V semiconductor material and a channel region of type III-V semiconductor material that forms a heterojunction with the barrier region, thereby forming a two-dimensional charge carrier gas channel within the channel region; first and second electrodes that are each in electrical contact with the two-dimensional charge carrier gas channel; and a gate structure disposed on an upper surface of the semiconductor body laterally in between the first and second electrodes and configured to control a conduction state of the two-dimensional charge carrier gas channel, wherein the gate structure comprises a gate electrode and a first region of doped type III-V semiconductor material in between the gate electrode and the two-dimensional charge carrier gas channel, wherein the first region of doped type III-V semiconductor material comprises a plurality of side faces that define a plan view geometry of the first region, and wherein in the plan view geometry of the first region at least two lateral boundaries of the first region that intersect one another extend along crystallographically equivalent planes of the doped type III-V semiconductor material.

Example 2. The high-electron mobility transistor of example 1, wherein the first region of doped type III-V semiconductor material has a wurtzite crystal structure, and wherein at least two lateral boundaries of the first region that intersect one another are oriented at integer multiples of 60° relative to one another.

Example 3. The high-electron mobility transistor of example 1 or example 2, wherein the first region of doped type III-V semiconductor material is configured to deplete the two-dimensional charge carrier gas channel at zero gate bias.

Example 4. The high-electron mobility transistor of example 3, wherein the two-dimensional charge carrier gas channel is a two-dimensional electron gas, and wherein the first region of doped type III-V semiconductor material is a region of p-type GaN or alloys thereof.

Example 5. The high-electron mobility transistor of any one of examples 1 to 4, further comprising: a second region of doped type III-V semiconductor material disposed on the upper surface of the semiconductor body and electrically connected with the second electrode, wherein the second region of doped type III-V semiconductor material comprises a second plurality of side faces that define a plan view geometry of the second region, wherein in the plan view geometry of the second region at least two lateral boundaries of the second region that intersect one another extend along crystallographically equivalent planes of the doped type III-V semiconductor material.

Example 6. The high-electron mobility transistor of example 5, wherein the second region of doped type III-V semiconductor material is a region of p-type GaN or alloys thereof.

Example 7. The high-electron mobility transistor of any one of examples 1 to 6, wherein every one of the lateral boundaries of the first region extends along one of the crystallographically equivalent planes of the doped type III-V semiconductor material.

Example 8. The high-electron mobility transistor of any one of examples 1 to 7, wherein the high-electron mobility transistor comprises an enclosed ring of the doped type III-V semiconductor material that provides the first region, and wherein side faces of the enclosed ring form a first closed shape in the plan view geometry of the first region that faces and surrounds an interior region, wherein the first electrode or the second electrode is arranged within the interior region, and wherein every lateral boundary from the first closed shape extends along crystallographically equivalent planes of the doped type III-V semiconductor material.

Example 9. The high-electron mobility transistor of example 8, wherein the side faces of the enclosed ring form a second closed shape in the plan view geometry of the first region that forms an outer periphery of the enclosed ring, and wherein every lateral boundary from the second closed shape extends along one of the crystallographically equivalent planes of the doped type III-V semiconductor material.

Example 10. A high-electron mobility transistor, comprising: a semiconductor body comprising a barrier region of type III-V semiconductor material and a channel region of type III-V semiconductor material that forms a heterojunction with the barrier region, thereby forming a two-dimensional charge carrier gas channel within the channel region; a plurality of transistor cells formed in the semiconductor body, each of the transistor cells comprising first and second electrodes that are each in electrical contact with the two-dimensional charge carrier gas channel, and a gate structure comprising a gate electrode and a first region of doped type III-V semiconductor material in between the gate electrode and the two-dimensional charge carrier gas channel; and one or more regions of the doped type III-V semiconductor material that enclose one of the first or second electrodes and provide the first region of doped type III-V semiconductor material for each of the transistor cells, wherein the one or more regions of the doped type III-V semiconductor material comprises a plurality of side faces that define a plan view geometry of the one or more regions, and wherein at least two intersecting lateral boundaries in the plan view geometry of the one or more regions extend along crystallographically equivalent planes of the doped type III-V semiconductor material.

Example 11. The high-electron mobility transistor of example 10, wherein the plurality of transistor cells comprises a first row of the transistor cells and a second row of the transistor cells adjacent to the first row, and wherein at least some of the transistor cells from the first row are aligned with the transistor cells from the second row in a current flow direction of the transistor cells.

Example 12. The high-electron mobility transistor of example 10, wherein the plurality of transistor cells comprises a first row of the transistor cells and a second row of the transistor cells adjacent to the first row, and wherein the transistor cells from the first row are offset from the transistor cells from the second row in a current flow direction of the transistor cells.

Example 13. The high-electron mobility transistor of example 12, wherein the one or more regions of the doped type III-V semiconductor material comprises a plurality of enclosed rings of the doped type III-V semiconductor material, and wherein the enclosed rings that provide the first region of doped type III-V semiconductor material for the transistor cells from the first row overlap with the enclosed rings that provide the first region of doped type III-V semiconductor material for the transistor cells from the second row in a central region of the high-electron mobility transistor.

Example 14. The high-electron mobility transistor of example 13, wherein the at least two intersecting ones of the lateral boundaries from each one of the enclosed rings extends along the crystallographically equivalent planes of the doped type III-V semiconductor material.

Example 15. The high-electron mobility transistor of any one of examples 12 to 14, wherein the one or more regions of the doped type III-V semiconductor material comprises a continuous region of the doped type III-V semiconductor material that provides the first region of the gate structure for each of the transistor cells, and wherein the continuous region comprises a gate bus that connects with the first region of the gate structure for each of the transistor cells.

Example 16. The high-electron mobility transistor of example 15, wherein each of the lateral boundaries from the continuous region extends along one of the crystallographically equivalent planes of the doped type III-V semiconductor material.

Example 17. The high-electron mobility transistor of example 10, wherein the plurality of transistor cells comprises a first row of the transistor cells and a second row of the transistor cells adjacent to the first row, wherein the high-electron mobility transistor further comprises a continuous edge termination electrode that is disposed between outermost ones of the transistor cells from the first and second rows and an outer edge side of the semiconductor body.

Example 18. The high-electron mobility transistor of example 17, wherein the transistor cells from the first row are offset from the transistor cells from the second row in a current flow direction of the transistor cells, and wherein the outermost one of the transistor cells from the first row is differently configured from every other one of the transistor cells from the first row and the second row.

Example 19. The high-electron mobility transistor of any one of examples 10 to 18, wherein the doped type III-V semiconductor material has a wurtzite crystal structure, and wherein the at least two intersecting lateral boundaries of the side faces are oriented at integer multiples of 60° relative to one another.

Example 20. A high-electron mobility transistor, comprising: a semiconductor body comprising a barrier region of type III-V semiconductor material and a channel region of type III-V semiconductor material that forms a heterojunction with the barrier region, thereby forming a two-dimensional charge carrier gas channel within the channel region; first and second electrodes that are each in electrical contact with the two-dimensional charge carrier gas channel; and a gate structure disposed on an upper surface of the semiconductor body laterally in between the first and second electrodes and configured to control a conduction state of the two-dimensional charge carrier gas channel, wherein the gate structure comprises a gate electrode and a first region of doped type III-V semiconductor material in between the gate electrode and the two-dimensional charge carrier gas channel, wherein the first region of doped type III-V semiconductor material has a wurtzite crystal structure, and wherein from a plan view perspective of the first region side faces of the first region intersect one another at integer multiples of 60°.

As used herein, the phrase "III-V semiconductor material" refers to a compound material that includes at least one Group III element, such as aluminum (Al), gallium (Ga), indium (In), and boron (B) and at least one Group IV element, such as nitrogen (N), phosphorous (P), and arsenic (As), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. Aluminum gallium nitride and AlGaN refers to an alloy described by the formula AlₓGa₍₁₋ₓ₎N, where 0 < x < 1.

The term HEMT is also commonly referred to as HFET (heterostructure field effect transistor), MODFET (modulation-doped FET) and MESFET (metal semiconductor field effect transistor). The terms HEMT, HFET, MESFET and MODFET are used interchangeably herein to refer to any III-V based compound semiconductor transistor incorporating a junction between two materials with different band gaps (i.e., a heterojunction) as the channel.

Spatially relative terms such as "under," "below," "lower," "over," "upper" and the like, are used for ease of description to explain the positioning of one element relative to a second element. These terms are intended to encompass different orientations of the device in addition to different orientations than those depicted in the figures. Further, terms such as "first," "second," and the like, are also used to describe various elements, regions, sections, etc. and are also not intended to be limiting. Like terms refer to like elements throughout the description.

As used herein, the terms "having," "containing," "including," "comprising" and the like are open-ended terms that indicate the presence of stated elements or features, but do not preclude additional elements or features. The articles "a," "an" and "the" are intended to include the plural as well as the singular, unless the context clearly indicates otherwise.

With the above range of variations and applications in mind, it should be understood that the present invention is not limited by the foregoing description, nor is it limited by the accompanying drawings. Instead, the present invention is limited only by the following claims and their legal equivalents.

## Claims

1. A high-electron mobility transistor, comprising:
a semiconductor body comprising a barrier region of type III-V semiconductor material and a channel region of type III-V semiconductor material that forms a heterojunction with the barrier region, thereby forming a two-dimensional charge carrier gas channel within the channel region;
first and second electrodes that are each in electrical contact with the two-dimensional charge carrier gas channel; and
a gate structure disposed on an upper surface of the semiconductor body laterally in between the first and second electrodes and configured to control a conduction state of the two-dimensional charge carrier gas channel,
wherein the gate structure comprises a gate electrode and a first region of doped type III-V semiconductor material in between the gate electrode and the two-dimensional charge carrier gas channel,
wherein the first region of doped type III-V semiconductor material comprises a plurality of side faces that define a plan view geometry of the first region, and
wherein in the plan view geometry of the first region at least two lateral boundaries of the first region that intersect one another extend along crystallographically equivalent planes of the doped type III-V semiconductor material, and/or
wherein the first region of doped type III-V semiconductor material has a wurtzite crystal structure, and wherein at least two lateral boundaries of the first region that intersect one another are oriented at integer multiples of 60° relative to one another.

2. The high-electron mobility transistor of claim 1, wherein the two-dimensional charge carrier gas channel is a two-dimensional electron gas, and wherein the first region of doped type III-V semiconductor material is a region of p-type GaN or alloys thereof.

3. The high-electron mobility transistor of claim 1 or claim 2, further comprising:
a second region of doped type III-V semiconductor material disposed on the upper surface of the semiconductor body and electrically connected with the second electrode,
wherein the second region of doped type III-V semiconductor material comprises a second plurality of side faces that define a plan view geometry of the second region,
wherein in the plan view geometry of the second region at least two lateral boundaries of the second region that intersect one another extend along crystallographically equivalent planes of the doped type III-V semiconductor material.

4. The high-electron mobility transistor of claim 3, wherein the second region of doped type III-V semiconductor material is a region of p-type GaN or alloys thereof.

5. The high-electron mobility transistor of any one of claims 1 to 4, wherein every one of the lateral boundaries of the first region extends along one of the crystallographically equivalent planes of the doped type III-V semiconductor material.

6. The high-electron mobility transistor of any one of claims 1 to 5, wherein the high-electron mobility transistor comprises an enclosed ring of the doped type III-V semiconductor material that provides the first region, and wherein side faces of the enclosed ring form a first closed shape in the plan view geometry of the first region that faces and surrounds an interior region, wherein the first electrode or the second electrode is arranged within the interior region, and wherein every lateral boundary from the first closed shape extends along crystallographically equivalent planes of the doped type III-V semiconductor material.

7. The high-electron mobility transistor of claim 6, wherein the side faces of the enclosed ring form a second closed shape in the plan view geometry of the first region that forms an outer periphery of the enclosed ring, and wherein every lateral boundary from the second closed shape extends along one of the crystallographically equivalent planes of the doped type III-V semiconductor material.

8. A high-electron mobility transistor, comprising:
a semiconductor body comprising a barrier region of type III-V semiconductor material and a channel region of type III-V semiconductor material that forms a heterojunction with the barrier region, thereby forming a two-dimensional charge carrier gas channel within the channel region;
a plurality of transistor cells formed in the semiconductor body, each of the transistor cells comprising first and second electrodes that are each in electrical contact with the two-dimensional charge carrier gas channel, and a gate structure comprising a gate electrode and a first region of doped type III-V semiconductor material in between the gate electrode and the two-dimensional charge carrier gas channel; and
one or more regions of the doped type III-V semiconductor material that enclose one of the first or second electrodes and provide the first region of doped type III-V semiconductor material for each of the transistor cells,
wherein the one or more regions of the doped type III-V semiconductor material comprises a plurality of side faces that define a plan view geometry of the one or more regions, and
wherein at least two intersecting lateral boundaries in the plan view geometry of the one or more regions extend along crystallographically equivalent planes of the doped type III-V semiconductor material.

9. The high-electron mobility transistor of claim 8, wherein the plurality of transistor cells comprises a first row of the transistor cells and a second row of the transistor cells adjacent to the first row, and wherein at least some of the transistor cells from the first row are aligned with the transistor cells from the second row in a current flow direction of the transistor cells.

10. The high-electron mobility transistor of claim 8, wherein the plurality of transistor cells comprises a first row of the transistor cells and a second row of the transistor cells adjacent to the first row, and wherein the transistor cells from the first row are offset from the transistor cells from the second row in a current flow direction of the transistor cells.

11. The high-electron mobility transistor of claim 10, wherein the one or more regions of the doped type III-V semiconductor material comprises a plurality of enclosed rings of the doped type III-V semiconductor material, and wherein the enclosed rings that provide the first region of doped type III-V semiconductor material for the transistor cells from the first row overlap with the enclosed rings that provide the first region of doped type III-V semiconductor material for the transistor cells from the second row in a central region of the high-electron mobility transistor.

12. The high-electron mobility transistor of claim 10 or claim 11, wherein the one or more regions of the doped type III-V semiconductor material comprises a continuous region of the doped type III-V semiconductor material that provides the first region of the gate structure for each of the transistor cells, and wherein the continuous region comprises a gate bus that connects with the first region of the gate structure for each of the transistor cells.

13. The high-electron mobility transistor of claim 8, wherein the plurality of transistor cells comprises a first row of the transistor cells and a second row of the transistor cells adjacent to the first row, wherein the high-electron mobility transistor further comprises a continuous edge termination electrode that is disposed between outermost ones of the transistor cells from the first and second rows and an outer edge side of the semiconductor body.

14. The high-electron mobility transistor of claim 13, wherein the transistor cells from the first row are offset from the transistor cells from the second row in a current flow direction of the transistor cells, and wherein the outermost one of the transistor cells from the first row is differently configured from every other one of the transistor cells from the first row and the second row.

15. The high-electron mobility transistor of any one of claims 8 to 14, wherein the doped type III-V semiconductor material has a wurtzite crystal structure, and wherein the at least two intersecting lateral boundaries of the side faces are oriented at integer multiples of 60° relative to one another.
